# EUROPÄISCHE PATENTANMELDUNG

(11) **EP 2 264 760 A2**
(43) Veröffentlichungstag der Anmeldung: **22.12.2010**
(21) Anmeldenummer: 10004375.1
(22) Anmeldetag: 24.04.2010
(51) Int. Cl.: H01L 25/07, H01L 23/373, H01L 23/00

(54) **Steueranschlusskontakteinrichtung für ein Leistungshalbleiterbauelement**

(30) Priorität: 09.06.2009 DE 102009024421
(71) Anmelder: SEMIKRON Elektronik GmbH & Co. KG, 90431 Nürnberg (DE)
(72) Erfinder: Ebersberger, Frank, 90518 Altdorf (DE); Seidler, Andreas, 90522 Oberasbach (DE)

(57) **Zusammenfassung**

Steueranschlusskontakteinrichtung zur Kontaktierung des Steueranschlusses eines Leistungshalbleiterbauelements in einem Leistungshalbleitermodul, wobei beabstandet vom Leistungshalbleiterbauelement ein Isolierstoffkörper angeordnet ist, der eine erste und eine zweite Ausnehmung aufweist, mit mindestens einer Kontakteinrichtung zur Steueranschlusskontaktierung des Leistungshalbleiterbauelements, wobei die Kontakteinrichtung zur Anordnung in dem Isolierstoffkörper vorgesehen ist und einen stiftartigen Fortsatz aufweist, der durch die erste Ausnehmung hindurchreicht und das Leistungshalbleiterbauelement kontaktiert und zwischen der Kontakteinrichtung und einer Verbindungseinrichtung einen Metallformkörper aufweist,
wobei die Verbindungseinrichtung parallel zum Leistungshalbleiterbauelement durch die zweite Ausnehmung hindurchsteckbar angeordnet ist und elektrisch leitend mit dem Metallformkörper verbindbar ist.

## Beschreibung

Die vorliegende Erfindung betrifft eine Steueranschlusskontakteinrichtung zur Druckkontaktierung des Steueranschlusses eines Leistungshalbleiterbauelements vorzugsweise mindestens eines Leistungshalbleitermoduls. Derartige Steuerkontakteinrichtungen eines Leistungshalbleiterbauelement sind beispielhaft aus den DE 10 2004 050 588 A1, DE 10 2006 034 964 B3 und DE 10 2007 010 883 A1 bekannt.

Erstgenannte Druckschrift offenbart eine Anordnung mit einem Leistungshalbleiterbauelement in einem Leistungshalbleitermodul oder einer Scheibenzelle, wobei oberhalb des Leistungshalbleiterbauelements ein Formkörper angeordnet ist, der im Bereich des Steueranschlusses eine Ausnehmung mit einem Widerlager aufweist. Die Kontakteinrichtung selbst besteht aus einer Kontaktfeder mit einem stiftartigen Fortsatz an demjenigen Federende, das den Steueranschluss kontaktiert, und weiterhin mit einer mittels eines Metallformteils gebildeten Steckverbindung mit einem Anschlusskabel zur externen Verbindung am anderen Federende. Die Kontakteinrichtung weist hierzu eine Isolierstoffhülse mit darin angeordneter Kontaktfeder auf, wobei die Isolierstoffhülse weiterhin Rastnasen aufweist, die zusammen mit einem Widerlager des Formkörpers eine Schnapp-Rast-Verbindung bilden. Nachteilig an dieser Ausgestaltung der Kontakteinrichtung ist, dass sie eine große Bauhöhe aufweist und daher in manchen kompakten Leistungshalbleitermodulen oder Scheibenzellen nicht angeordnet werden kann.

Weiter ist aus der DE 10 2006 034 964 B3 ein Leistungshalbleitermodul mit einem Leistungshalbleiterbauelement bekannt, wobei das Leistungshalbleitermodul ein Isolierstoffgehäuse aufweist und in diesem Isolierstoffgehäuse eine seitlich angeordnete Ausnehmung für eine Verbindungseinrichtung mit einem Anschlusskabel vorgesehen ist.

Aus der DE 10 2007 010 883 A1 ist eine Leistungshalbleiteranordnung mit einem Leistungshalbleitermodul und einem Schaltungsträger bekannt. Die Leistungshalbleiteranordnung weist eine Grundplatte und ein Anschlusselement auf, wobei das Anschlusselement senkrecht aus dem Gehäuse herausführt und an diesem befestigt ist. Das Anschlusselement kann als Druckkontakt oder als Steckkontakt ausgeführt sein.

Der Stand der Technik weist Lötverbindungen zwischen dem Steueranschluss des Leistungshalbeiterbauelements sowie verschiedene Arten von federbelasteten Druckkontaktierungen auf. Der Nachteil gemäß dem Stand der Technik ist, dass die verschiedenen Arten von federbelasteten Druckkontaktierungen eine komplexe Herstellung des Leistungshalbleitermoduls bedingen.

Der Erfindung liegt die Aufgabe zugrunde eine Anordnung einer Steueranschlusskontakteinrichtung für ein Leistungshalbleiterbauelement in einem Leistungshalbleitermodul zu schaffen, die universell einsetzbar ist, einen dauerhaft sicheren elektrischen Kontakt gewährleistet, eine einfache Montage und die Beaufschlagung des Druckkontakts für den Steueranschluss des Leistungshalbleiterbauelements als letzten Montageschritt aufweist.

Diese Aufgabe wird erfindungsgemäß gelöst durch die Maßnahmen der Merkmale des Anspruchs 1. Bevorzugte Ausführungsformen sind in den abhängigen Ansprüchen beschrieben.

Der Grundgedanke der Erfindung geht aus von einem Leistungshalbleitermodul mit mindestens einem gesteuerten Leistungshalbleiterbauelement, beispielhaft einen Thyristor oder einen Transistor. Diese weisen pro Leistungshalbleiterbauelement einen Steueranschluss auf, der von außerhalb des Leistungshalbleitermoduls mit einem Signal angesteuert wird.

Die erfindungsgemäße Anordnung mit einem Leistungshableiterbauelement in einem Leitungshalbleitermodul weist hierbei eine Steueranschlusskontakteinrichtung mit einem mehrteiligen Isolierstoffkörper mit einer ersten Ausnehmung und einer zweiten Ausnehmung auf. Innerhalb des Isolierstoffkörpers angeordnet eine Kontakteinrichtung zur Steueranschlusskontaktierung des Leistungshalbleiterbauelements. Die Kontakteinrichtung ausgebildet als Kontaktfeder mit einem stiftartigen Fortsatz, der durch die erste Ausnehmung hindurchreicht und das Leistungshalbleiterbauelement am Steueranschluss kontaktiert.

Eine Verbindungseinrichtung ist parallel zum Leistungshalbleiterbauelement durch eine zweite Ausnehmung hindurchsteckbar angeordnet. Zwischen der Kontakteinrichtung und der Verbindungseinrichtung ist ein kugelförmiger Metallformkörper angeordnet. Durch hindurchstecken der beispielhaft stiftartig ausgebildeten Verbindungseinrichtung durch die zweite Ausnehmung, wird der kugelförmige Metallformkörper mit Druck beaufschlagt, verdrängt dadurch den kugelförmigen Metallformkörper nach unten und spannt die Kontaktfeder der Kontakteinrichtung. Vorteilhaft an dieser Ausbildung einer Steueranschlusskontakteinrichtung ist, dass die Kontaktfeder der Kontakteinrichtung erst im letzten Montageschritt gespannt wird und somit eine Bewegung des Leistungshalbleiterbauelements bei gespannter Kontaktfeder während der Montage vermieden wird um somit über die Lebensdauer des Leistungshalbleitermoduls eine konstante Druckeinleitung und damit elektrisch sichere Kontaktierung des Steueranschlusses des Leistungshalbleiterbauelements zu gewährleisten.

Eine bevorzugte Ausbildung der Verbindungseinrichtung weist an einem Ende eine derart ausgebildete Einschnürung auf, dass die im Wesentlichen stiftartig ausgebildete Verbindungseinrichtung formschlüssig auf dem kugelförmig ausgebildeten Metallformkörper aufliegt. Der Grund dafür ist, dass die Kontakteinrichtung, der Metallformkörper sowie die Verbindungseinrichtung elektrisch leitend miteinander in Verbindung stehen. Um eine sichere elektrisch leitende Verbindung zu gewährleisten müssen die Komponenten formschlüssig miteinander in Verbindung stehen und aus einem elektrisch leitenden Material bestehen beispielhaft aus Aluminium, Silber oder Kupfer oder einem anderen elektrisch leitenden Material. Weiter ist darauf zu achten, dass an den Kontaktstellen zwischen Verbindungseinrichtung und Metallformkörper sowie Metallformkörper und Kontakteinrichtung eine ausreichende Oberflächengüte gewährleistet ist. Für einen sicheren elektrischen Kontakt ist weiter darauf zu achten, dass keine rauen Kontaktstellen oder Verschmutzungen zwischen den Kontaktstellen vorhanden sind.

Weiter weist die Steueranschlusskontakteinrichtung einen mehrteiligen Isolierstoffkörper auf, aus einem ersten Teilkörper und einem zweiten Teilkörper. Innerhalb des Isolierstoffkörpers ist eine Kontakteinrichtung, ein kugelförmiger Metallformkörper und eine Verbindungseinrichtung, die durch eine zweite Ausnehmung aus dem ersten Teilkörper hinausragt zu einer externen Verbindung zur elektrischen Kontaktierung, angeordnet. Der zweite Teilkörper fungiert als Deckel zum verschließen des Isolierstoffkörpers und ist über eine Dreh-Rast-Verbindung auf dem ersten Teilkörper angeordnet. Die Verbindungseinrichtung weist eine Hülse auf, die in Richtung des Isolierstoffkörpers auf der Mantelfläche verjüngt und in den ersten Teilkörper durch eine Ausnehmung hineinragt und die Verbindungseinrichtung vom Leistungshalbleitermodul isoliert. Die Hülse kann durch eine Verbindungseinrichtung die in Kunststoff eingespritzt ist ersetzt werden.

Der mehrteilige Isolierstoffkörper der vorliegenden Erfindung weist auf dem zweiten Teilkörper eine Einbuchtung und einen Zapfen zur Fixierung des Isolierstoffkörpers auf. Diese derart ausgebildete Einbuchtung begrenzt Bewegungen in lateraler Richtung und der Zapfen wirkt einer Rotation des Isolierstoffkörpers entgegen und verhindert weiter, dass sich der zweite Teilkörper von dem ersten Teilkörper selbstständig durch Erschütterungen löst.

Der erfinderische Gedanke wird anhand der Ausführungsbeispiele in den Fig. 1 bis Fig. 4 näher erläutert.
- Figur 1: zeigt eine Schnittansicht der erfindungsgemäßen Steueranschlusskontakteinrichtung.
- Figur 2: zeigt eine dreidimensionale Ansicht der erfindungsgemäßen Steueranschlusskontakteinrichtung.
- Figur 3: zeigt eine Vorderansicht des Aufnahmekörpers der erfindungsgemäßen Steueranschlusskontakteinrichtung.
- Figur 4: zeigt eine Schnittansicht eines Leistungshalbleiterbauelements mit erfindungsgemäßer Steueranschlusskontakteinrichtung.

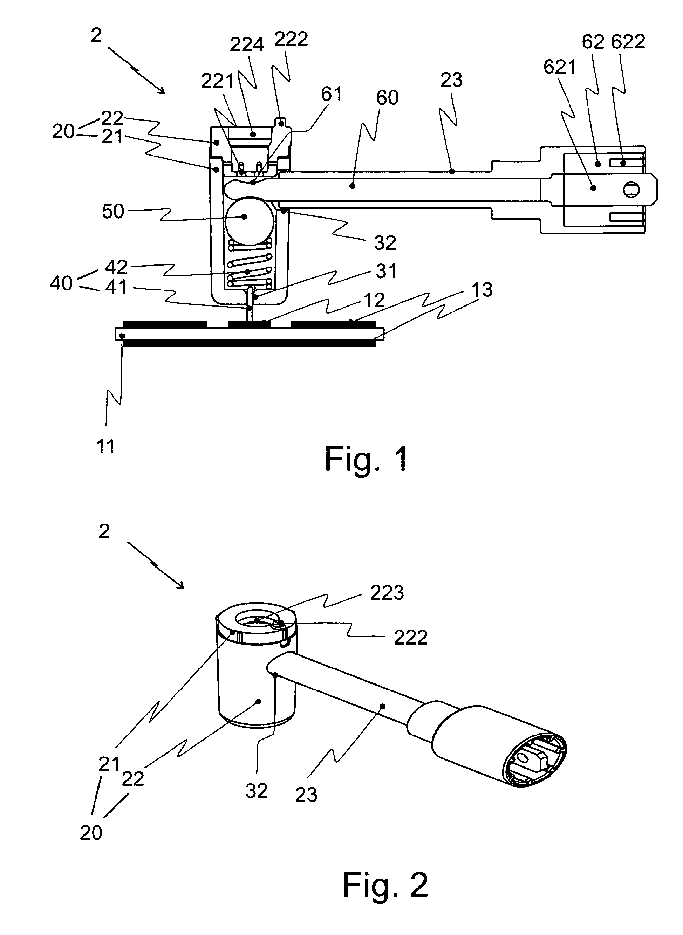

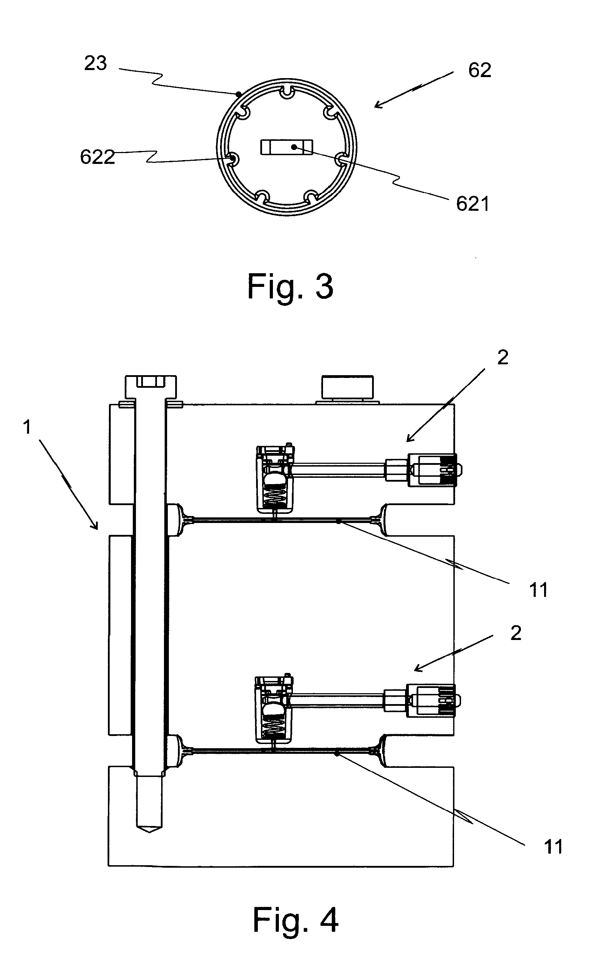

Fig. 1 zeigt eine Schnittansicht der erfindungsgemäßen Steueranschlusskontakteinrichtung. Die Steueranschlusskontakteinrichtung weist einen mehrteiligen Isolierstoffkörper (20) aus einem ersten Teilkörper (21) und einen zweiten Teilkörper (22) auf. Der erste Teilkörper (21) und der zweite Teilkörper (22) sind angeordnet über eine Dreh-Rast-Verbindung (221). Weiter weist der zweite Teilkörper (22) eine Einbuchtung (223) und einen Zapfen (222), angeordnet auf der dem ersten Teilkörper (21) hin abgewandten Seite (20), damit sich der Isolierstoffkörper (20) nicht innerhalb der Aufnahme im Leistungshalbleitermodul (1) in lateraler Richtung verschieben sowie einer Drehbewegung des Isolierstoffkörpers (20) entgegensteht.
Der Isolierstoffkörper (20) weist eine erste (31) und eine zweite Ausnehmung (32) auf. Innerhalb des Isolierstoffkörpers (20) ist eine Kontakteinrichtung (40) angeordnet, die eine Kontaktfeder (41) mit einem stiftartigen Fortsatz (42) aufweist, die durch die erste Ausnehmung (31) des ersten Isolierstoffkörpers hindurchragt und das Leistungshalbleiterbauelement, das weitere Hauptanschlüsse (13) für den zu schaltenden Laststrom aufweist, am Steueranschluss (12) kontaktiert. Weiter ist eine Verbindungseinrichtung (60), parallel zum Leistungshalbleiterbauelement (11) und durch die zweite Ausnehmung (32) hindurchsteckbar angeordnet. Zwischen der stiftartigen Verbindungseinrichtung (60) und der kugelförmigen Kontakteinrichtung (40) ist ein Metallformkörper (50) angeordnet und elektrisch leitend mit der Verbindungseinrichtung (60) sowie der Kontakteinrichtung (40) verbunden. Die Verbindungseinrichtung (60) weist an einem Ende eine Einschnürung (61) für die Kontaktierung mit dem Metallformkörper (50) auf, am gegenüberliegenden Ende einen Aufnahmekörper (62) zur externen Verbindung. Die Einschnürung (61) liegt formschlüssig auf dem Metallformkörper (50) und der Metallformkörper (50) liegt formschlüssig auf der Kontakteinrichtung (40) auf. Die Verbindungseinrichtung (60) wird durch eine Hülse (23) aus Kunststoff von der Umgebung isoliert. Der Aufnahmekörper (62) weist ein Anschlusselement (621) mit einem Verdrehschutz (622) zur externen Verbindung auf. Weiter weist die Hülse (23) eine Verjüngung der Mantelfläche in Richtung des Isolierstoffkörpers (20) auf, worauf beispielhaft ein Außengewinde angeordnet sein kann zur Fixierung der Hülse (23) beispielhaft im Kühlkörper eines Leistungshalbleitermoduls (vgl. Fig. 4, 1).

Fig. 2 zeigt eine dreidimensionale Ansicht der erfindungsgemäßen Steueranschlusskontakteinrichtung (2). Diese bestehend aus einem ersten Teilkörper (21) und einem zweiten Teilkörper (22), wobei der Isolierstoffkörper (20) die zweite Ausnehmung (32) aufweist in dem die Verbindungseinrichtung (vgl. Fig. 1, 60) mit der Hülse (23) hineinragt. Weiter weist die Hülse (23), eine Verjüngung des Umfangs in Richtung des Isolierstoffkörpers (20) auf, worauf beispielhaft ein Außengewinde angeordnet sein kann zur Fixierung der Verbindungseinrichtung (vgl. Fig. 1, 60) beispielhaft in einem Kühlkörper eines Leistungshalbleitermoduls (1). Der zweite Teilkörper (22) weist eine Einbuchtung (223) und einen Zapfen (222) auf, angeordnet auf der zum ersten Teilkörper (21) hin abgewandten Seite (20). Die Einbuchtung (223) fixiert den Isolierstoffkörper (20) in der Aufnahme des Leistungshalbleitermoduls (vgl. Fig. 4, 1) in lateraler Richtung und der Zapfen (222) fixiert den Isolierstoffkörper (20), um einer Rotation des Isolierstoffkörpers entgegen zu wirken.

Fig. 3 zeigt eine Vorderansicht des Aufnahmekörpers (62) der erfindungsgemäßen Steueranschlusskontakteinrichtung (2). Der Aufnahmekörper (62), angeordnet auf der zum Isolierstoffkörper (20) hin abgewandten Seite der Verbindungseinrichtung (vgl. Fig. 1, 60) mit der Hülse (23), weist ein Anschlusselement (621) zur externen Verbindung und einen Verdrehschutz (622) angepasst an einen bestimmten Anschluss auf.

Fig. 4 zeigt eine Schnittansicht eines Leistungshalbleitermoduls mit erfindungsgemäßer Steueranschlusskontakteinrichtung. Die Steueranschlusskontakteinrichtung (2) ist innerhalb der Teilkörper eines Leistungshalbleitermoduls (1), die als Kühleinrichtung sowie als Potentialübertragungsmittel dienen, angeordnet um den Steueranschluss (vgl. Fig. 1, 12) eines Leistungshalbleiterbauelements (11) zu kontaktieren. Der mehrteilige Isolierstoffkörper (vgl. Fig. 1, 20) der Steueranschlusskontakteinrichtung (2) muss vor dem zueinander fixieren der Teilkörper des Leistungshalbleitermoduls (1) in die Aufnahme für die Steueranschlusskontakteinrichtung (2) eingebracht werden. Die Verbindungseinrichtung (vgl. Fig. 1, 60) mit der Hülse (vgl. Fig. 1, 23) soll erst nach der Montage des Leistungshalbleitermoduls (1) in die Teilkörper eingeschraubt werden und spannt dadurch über den Metallformkörper (vgl. Fig. 1, 50) die Kontaktfeder (vgl. Fig. 1, 41) der Kontakteinrichtung (vgl. Fig. 1, 40) um über die Lebensdauer des Leistungshalbleitermoduls (1) eine konstante Druckeinleitung und damit elektrisch sichere Kontaktierung des Steueranschlusses (12) des Leistungshalbleiterbauelements (11) zu gewährleisten.

### Bezugszeichenliste:

- 1.: Leistungshalbleitermodul
- 2.: Steueranschlusskontakteinrichtung
- 11.: Leistungshalbleiterbauelement
- 12.: Steueranschluss
- 13.: Hauptanschluss
- 20.: Isolierstoffkörper
- 21.: erster Teilkörper
- 22.: zweiter Teilkörper
- 221.: Dreh-Rast-Verbindung
- 222.: Zapfen
- 223.: Einbuchtung
- 23.: Hülse
- 31.: erste Ausnehmung
- 32.: zweite Ausnehmung
- 40.: Kontakteinrichtung
- 41.: Kontaktfeder
- 42.: stiftartiger Fortsatz
- 50.: Metallformkörper
- 60.: Verbindungseinrichtung
- 61.: Einschnürung
- 62.: Aufnahmekörper
- 621.: Anschlusselement
- 622.: Verdrehschutz

## Patentansprüche

1. Steueranschlusskontakteinrichtung (2) zur Kontaktierung des Steueranschlusses eines Leistungshalbleiterbauelements (11) in einem Leistungshalbleitermodul (1), wobei beabstandet vom Leistungshalbleiterbauelement (11) ein Isolierstoffkörper (20) angeordnet ist, der eine erste (31) und eine zweite Ausnehmung (32) aufweist, mit mindestens einer Kontakteinrichtung (40) zur Steueranschlusskontaktierung des Leistungshalbleiterbauelements (11), wobei die Kontakteinrichtung (40) zur Anordnung in dem Isolierstoffkörper (20) vorgesehen ist und einen stiftartigen Fortsatz (42) aufweist, der durch die erste Ausnehmung (31) hindurchreicht und das Leistungshalbleiterbauelement (11) kontaktiert und wobei zwischen der Kontakteinrichtung (40) und einer Verbindungseinrichtung (60) ein Metallformkörper (50) angeordnet ist,
wobei die Verbindungseinrichtung (60) parallel zum Leistungshalbleiterbauelement (11) durch die zweite Ausnehmung (32) hindurchsteckbar angeordnet ist und elektrisch leitend mit dem Metallformkörper (50) verbindbar ist.

2. Steueranschlusskontakteinrichtung (2) nach Anspruch 1, wobei der Metallformkörper (50) kugelförmig und die Verbindungseinrichtung (60) stiftartig mit einer Einschnürung (61) ausgebildet ist.

3. Steueranschlusskontakteinrichtung (2) nach Anspruch 1 und 2, wobei die Verbindungseinrichtung (60) an einem Ende die Einschnürung (61) für die Kontaktierung mit dem Metallformkörper (60), am gegenüberliegenden Ende einen Aufnahmekörper (62) zur externen Verbindung aufweist und die Verbindungseinrichtung (60) zumindest teilweise durch eine Hülse (23) elektrisch isoliert ist.

4. Steueranschlusskontakteinrichtung (2) nach Anspruch 1 bis 3, wobei auch die Hülse (23) der Verbindungseinrichtung (60) in den ersten Teilkörper (21) durch die zweite Ausnehmung (32) hineinragt.

5. Steueranschlusskontakteinrichtung (2) nach Anspruch 1, wobei der Isolierstoffkörper (20) mehrteilig ausgebildet ist, aus einem ersten (21) und zweiten Teilkörper (22) die über eine Dreh-Rast-Verbindung (221) zueinander angeordnet sind.

6. Steueranschlusskontakteinrichtung (2) nach Anspruch 1 und 5, wobei der zweite Teilkörper (22) eine Einbuchtung (224) und einen Zapfen (222) aufweist um den mehrteiligen Isolierstoffkörper (20) im Leistungshalbleitermodul (1) in lateraler Richtung zu fixieren sowie einer Rotation des Isolierstoffkörpers (20) entgegen zu wirken.

7. Steueranschlusskontakteinrichtung (2) nach Anspruch 1, wobei die Kontakteinrichtung (40) als Schraubenfeder mit Kontaktstift ausgebildet ist.

8. Steueranschlusskontakteinrichtung (2) nach Anspruch 1, wobei die Verbindungseinrichtung (60), der Metallformkörper (50) und die Kontakteinrichtung (40) mit dem Leistungshalbleiterbauelement (11) elektrisch leitend verbunden sind und aus einem elektrisch leitenden Material bestehen.

9. Steueranschlusskontakteinrichtung (2) nach Anspruch 1 und 8, wobei die Einschnürung (61) der Verbindungseinrichtung (60) formschlüssig auf dem Metallformkörper (50) aufliegt, sowie der Metallformkörper (50) formschlüssig auf der Kontakteinrichtung (40) aufliegt.

10. Steueranschlusskontakteinrichtung (2) nach Anspruch 1, wobei die Steueranschlusskontakteinrichtung (2) innerhalb des Kühlkörpers eines Leistungshalbleitermoduls (1) mit mindestens einem Leistungshalbleiterbauelement (11) angeordnet ist.
